# EUROPÄISCHE PATENTANMELDUNG

(11) **EP 1 593 975 A1**
(43) Veröffentlichungstag der Anmeldung: **09.11.2005**
(21) Anmeldenummer: 05007247.9
(22) Anmeldetag: 02.04.2005
(51) Int. Cl.: G01R 11/04, G01R 11/24, G01R 1/04

(54) **Stromzählereinrichtung**

(30) Priorität: 05.05.2004 DE 102004022127
(71) Anmelder: ABB PATENT GmbH, 68526 Ladenburg (DE)
(72) Erfinder: Eppe, Klaus-Peter, Dipl.-Ing., 69429 Waldbrunn (DE); Wieland, Ralf, Dipl.-Ing., 69429 Waldbrunn (DE)
(74) Vertreter: Miller, Toivo

(57) **Zusammenfassung**

Die Erfindung betrifft eine Stromzählereinrichtung mit einer Zählerplattform oder mit einem Adapter (10) zum Aufsetzen eines Haushaltszählers (11), insbesondere eines elektronischen Haushaltszählers (11), mit einer Trägerplatte (13), auf die der Haushaltszähler (11) aufgesetzt ist und durch die hindurch Kontaktfahnen (21, 21a, 61, 61 a, 62, 62a) des Haushaltszählers (11) zu Kontaktstücken (22, 23, 29) sowie Haltekrallen (18, 19, 20) in die Zählerplattform einführbar sind, wobei bei der Montage in die Betriebsstellung und aus dieser heraus die zu jeder Phase gehörenden Kontaktstücke (22, 23, 29) mittels einer Brücke (28) verbunden und voneinander getrennt werden. Zwischen der Trägerplatte (13) und den Kontaktstücken (22, 23, 29) ist eine verschiebbare Platte (30) angebracht, an deren den Kontaktstücken (22, 23, 29) zugewandten Seite Zapfen angeformt sind, die in Aussparungen (32) der Brücke (28) eingreifen. Zwischen der Trägerplatte (13) und der Platte (30) ist ein an der Platte (30) geführter Schieber (40) angeordnet, der bei demontierten Zähler die Schlitze (16, 17; 33, 34, 35, 36, 37, 38) in der Trägerplatte (13) und der Platte (30) abdeckt und der vom Zähler in die Stellung verschiebbar ist, in der der Schieber (40) die Schlitze (16, 17; 33, 34, 35, 36, 37, 38) freigibt.

## Beschreibung

Die Erfindung betrifft eine Stromzählereinrichtung gemäß dem Oberbegriff des Anspruches 1.

In einer elektrischen Installationsanlage, beispielsweise in einer Hausinstallationsanlage befindet sich wenigstens ein Zählerplatz, in dem wenigstens ein Haushaltsstromzähler installiert ist, über den der von dem Energieversorgungsunternehmen gelieferte Strom zu den Verbrauchern geführt wird, so dass die Menge des abgenommenen Stromes erfasst werden kann. Der Haushaltsstromzähler wird dabei auf ein sogenanntes Zählerkreuz am Zählerplatz montiert, was aufwendig ist.

Im Zuge der weiteren Entwicklung soll der Zähler auf einfachste Weise montiert werden können, was gemäß der DE 100 52 998 dadurch erfolgt, dass der Zähler mit seinen an seiner Bodenseite befindlichen Anschlusskontaktstiften ins Innere einer Zählerplattform eingeführt und dann in seine endgültige Stellung, d. h. in seine Betriebsstellung, durch Verschieben überführt wird. Dieser Verschiebevorgang erfolgt parallel zu einer Trägerplatte an der Zählerplattform.

Der in der DE 100 52 998 beschriebene Zähler ist ein elektronischer Haushaltszähler, auf den die Zählerplattform angepasst ist. Bei einer Neuinstallation wird der Zählerplatz fabrikseitig auf den Zähler angepasst; bei Nachrüstungen wird in zweckmäßiger Weise am Zählerplatz ein Adapter angebracht, der dann als Zählerplattform dient, auf die der Zähler aufgesetzt wird.

In der DE 10 2004 001 453 ist eine Stromzählereinrichtung beschrieben, bei der unterhalb der Zählerplattform Kontaktstücke vorgesehen sind, die als U-förmige Kontakttulpen ausgebildet sind. Diese Kontakttulpen sind so innerhalb der Plattform eingebaut, dass die Schenkel zweier zu einer Phase gehöriger Kontakttulpen miteinander fluchten. Zwischen den Kontaktstücken ist eine Brücke hin- und herverschiebbar geführt, wodurch einerseits eine Überbrückung der Kontaktstücke und andererseits eine Unterbrechung des Stromflusses zwischen den Kontaktstücken erreicht werden.

Wenn ein Zähleraustausch erfolgen soll, dann soll während der Austauschzeit eine Stromunterbrechung zum Verbraucher vermieden werden. Aus diesem Grunde sind die Brücken vorgesehen, die so bewegt werden, dass bei der Demontage, bevor die Anschlussfahnen am Zähler von den zugehörigen Kontaktstücken freikommen, die Brücken die beiden zusammengehörenden Kontaktstücke überbrücken, wodurch der Strom sowohl über den Zähler als auch über die Brücken fließt und eine zeitweise Überlappung des Stromflusses bewirkt wird. Sobald der Zähler demontiert ist, fließt der Strom nur über die Brücken, weswegen der Strom nicht mehr gezählt wird. Bei der Montage wird der Zähler auf die Zählerplattform aufgesetzt; die Kontaktfahnen am Zähler greifen in die Brücken ein, verschieben diese, wobei die Brücken solange noch die Kontaktstücke miteinander verbinden, bis die Kontaktfahnen am Zähler in die zugehörigen Kontaktstücke eingreifen; auch hierbei fließt der Strom zeitweise über die Brücken und den Zähler, bis der Zähler in seine endgültige Betriebsstellung verschoben ist und sich die Brücken in Trennstellung befinden.

Das Problem des Schutzes gemäß IP 3X ist bis jetzt noch nicht angesprochen worden.

Aufgabe der Erfindung ist es, eine Zählerplattform der eingangs genannten Art zu schaffen, die den Vorschriften gemäß IP 3X genügt.

Diese Aufgabe wird erfindungsgemäß durch die Merkmale des Anspruches 1 gelöst.

Erfindungsgemäß also ist unterhalb der Trägerplatte eine verschiebbare Platte angeordnet, an deren den Kontaktstücken zugewandten Fläche Zapfen angeformt sind, die in die Brücken eingreifen und diese bei Montage und Demontage des Zählers verschieben. Zwischen der Trägerplatte und der Platte ist ein an der Platte geführter Schieber angeordnet, der bei demontiertem Zähler die Schlitze in der Trägerplatte und der Platte abdeckt und der vom Zähler in die Stellung verschiebbar ist, in der der Schieber die Schlitze freigibt.

Durch die erfindungsgemäße Ausgestaltung des Schiebers auf der Platte sind jedenfalls bei demontiertem Zähler die Kontaktstücke von dem Schieber abgedeckt, so dass bei einer fehlerhaften Montage des Zählers ein Zugang der Kontaktfahnen zu den Kontaktstücken verhindert ist.

Da die Kontaktfahnen selbst nicht an elektrisches Potential gelegt werden können, wird dadurch die Schutzart IP 3X erreicht.

Gemäß einer besonders vorteilhaften Ausgestaltung der Erfindung ist am Schieber ein Riegel vorgesehen, der bei demontiertem Zähler in eine Aussparung in der Plattform oder im Adapter eingreift, so dass die Platte unverschieblich ist und erst bei Einsetzen des Zählers zusammen mit dem Schieber von diesem aus der Aussparung herausgleitet. Dadurch wird ebenfalls erreicht, dass ein Verschieben des Zählers bei einer Fehlmontage verhindert ist.

Weitere vorteilhafte Ausgestaltungen und Verbesserungen der Erfindung sind den weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen und weitere Vorteile näher erläutert und beschrieben werden.

### Es zeigen:

- Fig. 1: eine perspektivische Ansicht eines Adapters, teilweise aufgeschnitten, mit einem elektronischen Stromzähler,
- Fig. 2: Teile der inneren Komponenten des Adapters und
- Fig. 3: eine perspektivische Ansicht einer erfindungsgemäßen Platte mit Schieber.

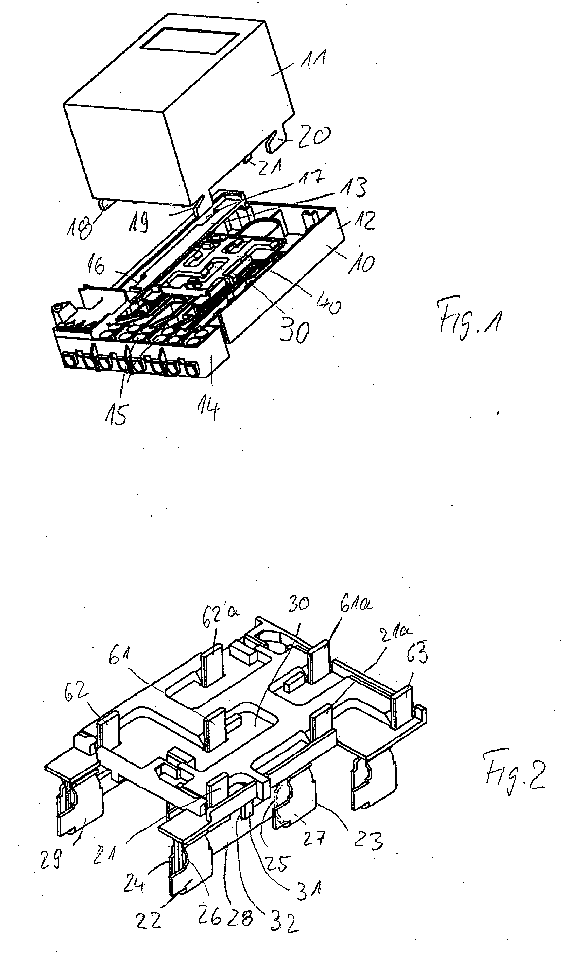

Die Fig. 1 zeigt eine Stromzählereinrichtung gemäß der Erfindung in perspektivischer Darstellung. Diese umfasst einen Adapter 10, auf dem ein elektronischer Haushaltszähler 11, im folgenden kurz Zähler genannt, aufgesetzt wird. Der Adapter 10 besitzt ein Gehäuseunterteil 12, das von einer Trägerplatte 13 abgedeckt ist. Am Adapter angeformt ist ein Gehäuseabschnitt, der zur Aufnahme von Anschlussklemmen d. h. von Zugangs- und Abgangsklemmen 15 dient.

Die Trägerplatte 13 ist mit Schlitzen 16, 17 versehen, die in der Nähe der einen Längskante angeordnet sind und die zur Aufnahme von Haltekrallen 18 bemessen sind. Auch an der anderen Längskante befinden sich in der Trägerplatte entsprechende Schlitze, die nicht dargestellt sind und durch die die Haltekrallen 19 und 20 hindurchgreifen. An der Unterseite des Stromzählers sind Kontaktfahnen angeordnet, von denen in der Fig. 1 lediglich eine Kontaktfahne 21 sichtbar ist. Eine entsprechende Darstellung des Stromzählers mit dem Adapter der DE 10 2004 001 453 zu entnehmen.

In dieser Patentanmeldung ist auch eine Aufsicht auf den Adapter dargestellt, in dessen Trägerplatte eine der Anzahl der Kontaktfahnen entsprechende Anzahl von Schlitzen vorgesehen ist. Dabei liegen jeweils zwei Schlitze auf je einer Linie, die parallel zu den Längskanten verläuft.

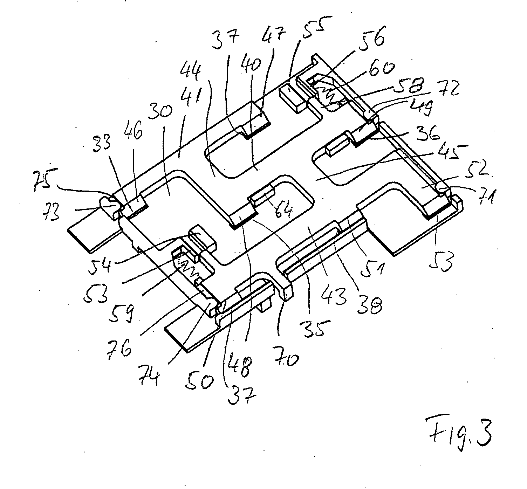

Unterhalb der Schlitze befinden sich Kontaktstücke, von denen in der Fig. 2 lediglich zwei zusammengehörige Kontaktstücke 22, 23 zu sehen sind. Diese Kontaktstücke sind als U-förmige Kontakttulpen ausgebildet, deren Schenkel 24, 25 und 26, 27 miteinander fluchten. Zwischen diesen Kontaktstücken 22, 23 ist eine Kontaktbrücke 28 verschiebbar, die in einer ersten Stellung die Kontaktstücke 22, 23 miteinander verbindet und die in einer zweiten Stellung die Kontaktstücke 22, 23 voneinander trennt. Die Fig. 2 zeigt noch ein weiteres Kontaktstück 29, dessen zugehöriges Kontaktstück nicht sichtbar ist. Diese Kontaktstücke 22, 23; 29 sind mit den Anschlussklemmen 15 verbunden wie in der DE 10 2004 001 453 dargestellt ist. Bezüglich dieser Ausgestaltungen wird ausdrücklich auf die DE 10 2004 001 453 verwiesen.

Unterhalb der Trägerplatte 13 befindet sich eine verschiebbare Platte 30, an deren der Kontaktstücken zugewandten Fläche senkrecht dazu verlaufende Vorsprünge 31 angeformt sind, die in Aussparungen 32 in der Brücke 28 eingreifen; für die Brücken der anderen Kontaktstücke sind ebenfalls entsprechende Zapfen vorgesehen, die in der Fig. 2 nicht sichtbar sind.

Beim Verschieben der Platte, bewirkt durch den Zähler 11, werden auch die Brücken 28 aller Phasen mit verschoben, so dass die Brücken 28 sich miteinander synchron bewegen.

In der Platte 28 sind Schlitze 33, 34, 35, 36; 37 und 38 eingebracht, durch die hindurch die Kontaktmesser oder Kontaktfahnen am Zähler 11 hindurchgreifen, um mit den Kontaktstücken 22, 23; 29 in Verbindung zu gelangen.

Damit die Kontaktfahnen im demontierten Zustand des Zählers 11 nicht zugänglich sind, ist auf der Platte 28 ein Schieber 40 angeordnet, der senkrecht zu den Verbindungslinien der einander zugehörigen Schlitze z.B. 33, 34, 35, 36; 37, 38 verschiebbar geführt ist. Dieser Schieber weist drei parallel zu den Verbindungslinien der Schlitze verlaufende stangenartige Abschnitte 41, 42 und 43 auf, die miteinander über Verbindungsstege 44 und 45, die senkrecht zu der Verbindungslinie der Schlitze bzw. der zueinander zugehörigen Schlitze und senkrecht zu den Abschnitten 41 bis 43 verlaufen, verbunden sind.

An dem Abschnitt 41 sind senkrecht dazu verlaufende erste Deckel- oder Dachabschnitte 46, 47, an dem Abschnitt 42 senkrecht dazu verlaufende zweite Dachabschnitte 48, 49 und an dem Abschnitt 43 dritte Dachabschnitte 50 und 51 te 48, 49 und an dem Abschnitt 43 dritte Dachabschnitte 50 und 51 angeformt, die in dem Ausgangs- oder Ruhezustand des Schiebers, wenn also der Zähler 11 nicht montiert ist, die zugehörigen Schlitze überdecken; dabei überdecken die Dachabschnitte 46, 47 die Schlitze 33, 34, die Dachabschnitte 48 und 49 die Schlitze 35 und 36 und die Dachabschnitte 50 und 51 die Schlitze 37 und 38. An dem Abschnitt 43 ist senkrecht dazu ein Abdeckschenkel 52 angeformt, der mit seinem freien Enden einen Schlitz 53 überdeckt, durch den eine am Zähler 12 angeordnete Kontaktfahne für den Nullleiter das zugehörigen Kontaktstück (in den Zeichnungen nicht dargestellt) kontaktiert.

Alle Dachabschnitte 46, 47, 48, 49, 50 und 51 stehen in gleicher Richtung vor; sie sind paarweise gegeneinander versetzt wie die Schlitze 33, 34, 35, 36, 37, 38.

An der Platte 28 befinden sich Führungsstege 53, 54 sowie 55, 56, die je einen Kanal zwischen sich bilden und jeweils einen Vorsprung 57 bzw. 58 an dem Abschnitt 42 bzw. 43 aufnehmen und dadurch den Schieber führen.

Zwischen der Platte 30 und dem Schieber 40 befinden sich zwei Druckfedern 59, 60, die den Schieber in Richtung der Schlitze beaufschlagen, so dass die Dachabschnitte 46, 47, 48, 49, 50 und 51 immer in die Richtung gedrückt sind, in der sie die zugehörigen Schlitze abdecken.

An den Dachabschnitten 46, 47; 48, 49; 50, 51 und am Dachabschnitt 52 sind Abschrägungen vorgesehen, die die Dicke der Dachabschnitte 46, 47, 48, 49, 50, 51 zu ihrem freien Ende hin verringern, so dass dann, wenn der Zähler auf die Trägerplatte 13 aufgesetzt wird und die dort befindlichen Schlitze durchgreift, die Kontaktfahnen auf die Abschrägungen auftreffen und damit den Schieber in seiner Gesamtheit entgegen der Kraft der Federn 59, 60 in Pfeilrichtung P verschieben, so dass die Schlitze 33, 34, 35, 36, 37, 38 für die zugehörigen Kontaktfahnen zugänglich sind, wie aus Fig. 2 ersichtlich. Man erkennt in der Fig. 2 die einander zugehörigen Kontaktfahnen 21, 21 a, 61, 61 a und 62, 62a zusammen mit der Anschlussfahne 63 für den Nullleiter. Die Anordnung gemäß der Fig. 3 ist um 180° in der Ebene der Trägerplatte verdreht.

Nachzutragen ist noch, dass an der Platte 30 Anschläge 64 und 65 angeformt sind, gegen die im Schließzustand der Schieber 40 mit seinem stangenartigen Abschnitt 42 zum Anliegen kommt.

An der Längskante des Abschnittes 43, an dem die Dachabschnitte 50 und 51 angeformt sind, befindet sich ein Riegelelement 70, welches bei demontiertem Zähler die Platte überragt und sich in eine nicht näher dargestellte Aussparung im Gehäuseunterteil 12 einfügt, so dass durch dieses Verriegelungselement 70 die Platte 30 in der Schließstellung festgehalten ist. Wenn der Schieber in Pfeilrichtung P verschoben wird, dann gleitet die Verriegelung 70 aus der Aussparung im Gehäuseunterteil 12 und die Platte mit dem Schieber kann verschoben werden.

An den Kanten der Platte 28, die senkrecht zur Verbindungslinie der Schlitze verlaufen sind Anformungen 71, 72, 73, 74 angeformt, die den Schieber leicht überdecken, so dass der Schieber nach Montage nicht senkrecht zur Platte 28 herausgenommen werden kann. Zur Montage wird der Schieber so montiert, dass sich alle Dachabschnitte außerhalb dieser Anformungen 71 bis 73 befinden; wenn der Schieber freigegeben wird, wird er von den Federn 59, 60 gegen seine Anschläge 64, 65 angedrückt, so dass die senkrecht zu den Verbindungslinien der Schlitze verlaufenden Kanten von den Anformungen 71 bis 73 übergriffen sind.

Unterhalb der Anformungen 73, 74 ist am Schieber je ein Rücksprung 75, 76 vorgesehen, in die die Anformungen 73, 74 eingreifen.

Mit der erfindungsgemäßen Ausgestaltung mit der Platte 30 und dem Schieber 40 wird einerseits IP X3 erreicht und darüber hinaus auch eine Fehlmontage verhindert, weil der Schieber 40 erst dann verschoben werden kann, wenn alle die Kontaktfahnen 21, 21 a; 61, 61a, 62, 62a auf die Abschrägung der Dachabschnitte aufgesetzt sind, wie dies in Fig. 2 dargestellt ist.

Die Fig. 1 zeigt, wie eingangs erwähnt, einen Einblick in den Adapter bzw. in das Gehäuseunterteil, und man erkennt die Platte 30 und den Schieber 40.

## Patentansprüche

1. Stromzählereinrichtung mit einer Zählerplattform oder mit einem Adapter (10) zum Aufsetzen eines Haushaltszählers (11), insbesondere eines elektronischen Haushaltszählers (11), mit einer Trägerplatte (13), auf die der Haushaltszähler (11) aufgesetzt ist und durch die hindurch Kontaktfahnen (21, 21a, 61, 61a, 62, 62a) des Haushaltszählers (11) zu Kontaktstücken (22, 23, 29) sowie Haltekrallen (18, 19, 20) in die Zählerplattform einführbar sind, wobei bei der Montage in die Betriebsstellung und aus dieser heraus die zu jeder Phase gehörenden Kontaktstücke (22, 23, 29) mittels einer Brücke (28) verbunden und voneinander getrennt werden, **dadurch gekennzeichnet, dass** zwischen der Trägerplatte (13) und den Kontaktstücken (22, 23, 29) eine verschiebbare Platte (30) angebracht ist, an deren den Kontaktstücken (22, 23, 29) zugewandten Seite Zapfen angeformt sind, die in Aussparungen (32) der Brücke (28) eingreifen und dass zwischen der Trägerplatte (13) und der Platte (30) ein an der Platte (30) geführter Schieber (40) angeordnet ist, der bei demontierten Zähler die Schlitze (16, 17; 33, 34, 35, 36, 37, 38) in der Trägerplatte (13) und der Platte (30) abdeckt und der vom Zähler in die Stellung verschiebbar ist, in der der Schieber (40) die Schlitze (16, 17; 33, 34, 35, 36, 37, 38) freigibt.

2. Einrichtung nach Anspruch 1, **dadurch gekennzeichnet, dass** der Schieber (40) zur Freigabe der Schlitze (16, 17; 33, 34, 35, 36, 37, 38) in der Platte (30) entgegen der Kraft wenigstens einer Feder verschiebbar ist.

3. Einrichtung nach Anspruch 1 oder 2, **dadurch gekennzeichnet, dass** am Schieber (40) ein Riegel vorgesehen ist, der bei demontierten Zähler in eine Aussparung in der Plattform oder im Adapter (10) eingreift, so dass die Platte (30) unverschieblich ist, und bei Einsetzen des Zählers zusammen mit dem Schieber (40) von diesem aus der Aussparung herausgleitet.

4. Einrichtung nach einem der vorherigen Ansprüche, **dadurch gekennzeichnet, dass** am Schieber (40) eine der Anzahl der Schlitze (16, 17; 33, 34, 35, 36, 37, 38) entsprechende Anzahl von Deckabschnitten angeformt sind, die bei demontierten Zähler die Schlitze (16, 17; 33, 34, 35, 36, 37, 38) überdecken, und dass an den Deckabschnitten Abschrägungen vorgesehen sind, über welche der Schieber (40) beim Einsetzen des Zählers von den Kontaktfahnen (21, 21a, 61, 61a, 62, 62a) am Zähler verschiebbar ist.

5. Einrichtung nach einem der vorherigen Ansprüche, **dadurch gekennzeichnet, dass** die Deckabschnitte an stangenförmigen Schieberabschnitten (41, 42, 43) angeformt sind, die durch Querstege miteinander verbunden sind.

6. Einrichtung nach einem der vorherigen Ansprüche, **dadurch gekennzeichnet, dass** die Dachabschnitte (46, 47, 48, 49, 50, 51) in gleiche Richtung vorspringen.

7. Einrichtung nach einem der vorherigen Ansprüche, **dadurch gekennzeichnet, dass** der Schieber senkrecht zu der Verbindungslinie jeweils zweier zugehöriger Schlitze verschiebbar ist.
